# EUROPEAN PATENT SPECIFICATION

(11) **EP 1 512 048 B1**
(45) Date of publication and mention of the grant of the patent: **07.03.2007**
(21) Application number: 02808354.1
(22) Date of filing: 16.05.2002
(51) Int. Cl.: G03F 7/00

(54) **METHOD FOR FABRICATING NANOSCALE PATTERNS IN LIGHT CURABLE COMPOSITIONS USING AN ELECTRIC FIELD**
VERFAHREN ZUR HERSTELLUNG VON STRUKTUREN AUF NANOMASSSTAB IN LICHTAUSHÄRTBAREN ZUSAMMENSETZUNGEN MIT EINEM ELEKTRISCHEN FELD
PROCEDE DE FABRICATION DE MOTIFS A NANO-ECHELLE DANS DES COMPOSITIONS DURCISSABLES A LA LUMIERE AU MOYEN D'UN CHAMP ELECTRIQUE

(30) Priority: 16.05.2001 US 291664 P
(43) Date of publication of application: 09.03.2005
(73) Proprietor: BOARD OF REGENTS, THE UNIVERSITY OF TEXAS SYSTEM, Austin, TX 78701 (US)
(72) Inventor: WILLSON, C., Grant, Austin, TX 78746-4448 (US); SREENIVASAN, S.V., Austin, TX 78750-3858 (US); BONNECAZE, Roger, T., Austin, TX 78703-3841 (US)
(74) Representative: Kirschner, Klaus Dieter
(86) International application number: PCT/US2002/015551
(87) International publication number: WO 2004/063815

(56) References cited:
- EP-A- 1 251 974
- WO-A-00/21689
- US-A- 4 119 688

## Description

This invention generally relates to the area of low cost, high -resolution, high-throughput lithography with the potential to make structures that are below 100nm in size:

Optical lithography techniques are currently used to make microelectronic devices. However, these methods are reaching their limits in resolution. Sub-micron scale lithography has been a critical process in the microelectronics industry. The use of sub -micron scale lithography allows manufacturers to meet the increased demand for smaller and more densely packed electronic components on chips. The finest structures producible in the microelectronics industry are currently on the order of about 0.13 µm. It is expected that in the coming years, the microelectronics industry will pursue structures that are smaller than 0.05 µm (50 nm). Further, there are emerging applications of nanometer scale lithography in the areas of opto-electronics and magnetic storage. For example, photonic crystals and high-density patterned magnetic memory of the order of terabytes per square inch require nanometer scale lithography.

For making sub-50 nm structures, optical lithography techniques may require the use of very short wavelengths of light (for instance 13.2 nm). At these short wavelengths, few, if any, materials are optically transparent and therefore imaging systems typically have to be constructed using complicated reflective optics, see "Getting More from Moore's," Gary Stix, Scientific American, April 2001. Furthermore, obtaining a light source that has sufficient output intensity at these wavelengths of light is difficult. Such systems lead to extremely complicated equipment and processes that appear to be prohibitively expensive. High-resolution e-beam lithography techniques, though very precise, typically are too slow for high-volume commercial applications.

A prior art imprint lithography technology is disclosed in WO 00/21689 from S. Y. Chou. and L. Zhuang.

One of the main challenges with current imprint lithography technologies is the need to establish direct contact between the template (master) and the substrate. The may lead to defects, low process yields, and low template life. Additionally, the template in imprint lithography typically is the same size as the eventual structures on the substrate (IX), as compared to 4X masks typically used in optical lithography. The cost of preparing the template and the life of the template are issues that may make imprint lithography impractical. Hence there exists a need for improved lithography techniques that address the challenges associated with optical lithography, e-beam lithography and imprint lithography for creating very high-resolution features.

It is an object of the invention to provide a method of preparing patterned structures on a substrate which can create very high-resolution features, and to provide an apparatus for altering a shape of a substrate for use in the method of the invention.

This object is achieved by the method of claim 1. Advantageous embodiments of the invention are characterized in the sub-claims.

In one embodiment, patterned structures are created on a substrate using imprint lithography. The process involves applying a polymerizable composition to the upper surface of the substrate. The substrate may be a substrate used to prepare a semiconductor device. Examples of substrates include, but are not limited to, Si wafers, GaAs wafers, SiGeC wafers, or an InP wafers. The polymerizable composition may be an ultraviolet light curable composition. The ultraviolet light curable composition may include a polymerizable monomer and a photoinitiator. The composition may be spin coated onto the substrate.

After the substrate has been coated with the polymerizable composition a template is placed above the polymerizable composition. The template is formed from an electrically conductive material. The template may also be substantially transparent to visible and/or ultraviolet light. The template may be formed of a combination of an electrically conductive material coupled to a non -conductive material. Both the electrically conductive material and the non-conductive material may be substantially transparent to light. The template may be formed of indium tin oxide and fused silica. The template includes a pattern of structures. The pattern of structures is complimentary to the pattern of structures which are to be produced on the substrate. At least a portion of the structures may have a feature size of less than about 100 nm.

An electric field is applied between the template and the substrate. The application of the electric field creates a static force that attracts at least a portion of the polymerizable composition toward the template. The portions of the polymerizable composition that are attracted to the template are complementary to the pattern of structures imprinted on the template. In one embodiment, the portions of the polymerizable composition that are attracted to the template come into contact with the template, while the remaining portions do not contact the template. Alternatively, neither the attracted portions nor the remaining portions of the polymerizable composition come into contact with the template. The attracted portions, however, extend toward the template while the un-attracted portions do not extend to the same extent that the attracted portions extend toward the template.

The polymerizable composition may be polymerized using an appropriate curing technique. For example, the polymerizable composition may include a photoinitiator and be curable by exposure to activating light while an electric field is applied to the template and the substrate. As used herein "activating light" means light that may affect a chemical change. Activating light may include ultraviolet light (e.g., light having a wavelength between about 300 nm to about 400 nm), actinic light, visible light or infrared light. Generally, any wavelength of light capable of affecting a chemical change may be classified as activating. Chemical changes may be manifested in a number of forms. A chemical change may include, but is not limited to, any chemical reaction that causes a polymerization or a cross -linking reaction to take place. The activating light may be passed through the template prior to reaching the composition. In this manner the polymerizable composition may be cured to form structures complementary to the structures formed on the template. Alternatively, the polymerizable composition may be cured by applying heat to the composition, while an electric field is applied to the template and the substrate.

After the polymerizable composition is cured, the structures may be further defined by etching the cured polymerizable composition. Etching may improve the aspect ratio of the structures. Any of the commonly used etching techniques may be used, including reactive ion etching.

In one embodiment, the template may be positioned less than about 1 µm from the polymerizable composition. The substrate should therefore have a planarity of less than about 1 µm, preferable less than about 0.25 µm. As used herein planarity is defined as the variance in curvature over the surface of the substrate. For example, a planarity of 1 µm indicates that the curvature of the surface varies by 1 µm above and/or below a center point which defines a planar surface.

To achieve a surface having a planarity of less than about 1 µm, the substrate may be placed on an apparatus configured to alter the shape of the substrate. The apparatus may include a holder configured to couple to and support the substrate. The apparatus may also include a plurality of pressure application devices coupled to the holder. The pressure application devices may be configured to apply a deforming force to the holder such that the shape of the holder is altered. The substrate may be coupled to the holder such that the changes in the shape of the holder may be imparted to the substrate. In this manner, the planarity of the substrate may be altered to conform to the desired planarity. The apparatus may include a programmable controller. The programmable controller may include a detection device configured to determine the planarity of the substrate. The controller may further be configured to operate the pressure application devices to alter the planarity of the substrate based on the determined planarity.

A high-throughput lithography process for creating high-resolution patterns in a polymerizable composition using carefully controlled electric fields followed by curing of the polymerizable composition is described. The process involves the use of a template that includes the desired patterns. This template is brought into close proximity to the polymerizable composition on the substrate. An external electric field is applied to the template-substrate interface while maintaining a uniform, carefully controlled gap between the template and substrate. This causes the polymerizable composition to be attracted to the raised portions of the template. By appropriately choosing the various process parameters such as the viscosity of the polymerizable composition, the magnitude of the electric field, and the distance between the template and substrate, the resolution of the structures formed in the liquid may be controlled to conform to that of the template.

Other objects and advantages of the invention will become apparent upon reading the following detailed description and upon reference to the accompanying drawings in which:
Fig. 1 depicts a template positioned over a substrate for electric field based lithography using UV curable compositions;
Fig. 2 depicts a schematic of a process for forming nanoscale structures using direct contact with a template;
Fig. 3 depicts a schematic of a process for forming nanoscale structures using non-direct contact with a template;
Fig. 4 depicts a substrate holder configured to alter the planarity of the substrate; and
Fig. 5 depicts an apparatus for positioning a template over a substrate.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within scope of the present invention as defined by the appended claims.

Recently imprint lithography techniques with UV curable liquids and polymers have been described for preparing nanoscale structures, see "Step and Flash Imprint Lithography: An alternative approach to high resolution patterning," M. Colburn, S. Johnson, M. Stewart, S. Damle, B. J. Choi, T. Bailey, M. Wedlake, T. Michaelson, S.V. Sreenivasan, J. Ekerdt, CG. Willson, Proc. SPIE Vol. 3676, 379-389, 1999, "Design of Orientation Stages for Step and Flash Imprint Lithography," B. J. Choi, S. Johnson, M. Colburn, S.V. Sreenivasan, C. G. Willson, To appear in J. of Precision Engineering, U.S. Patent Application No. 09/266,663 entitled "Step and Flash Imprint Lithography" to Grant Willson and Matt Colburn, U.S. Patent Application No. 09/698,317 entitled "High Precision Orientation Alignment and Gap Control Stages for Imprint Lithography Processes" to B.J. Choi, S.V. Sreenivasan and Steve Johnson, and "Large area high density quantized magnetic disks fabricated using nanoimprint lithography," W. Wu, B. Cui, X. Y. Sun, W. Zhang, L. Zhunag, and S. Y. Chou., J. Vac Sci Technol B 16 (6) 3825 -3829 Nov-Dec 1998. These techniques may potentially be significantly lower cost than optical lithography techniques for sub-50 nm resolution. Recent research has also investigated the possibility of applying electric fields and van der Waals attractions between a template that possesses topography and a substrate that contains a polymeric material to form nanoscale structures, see "Lithographically-induced Self-assembly of Periodic Polymer Micropillar Arrays," Zhuang, J Vac Sci Tech B 17 (6), 3197-3202, 1999 and "Large Area Domain Alignment in Block Copolymer Thin Films Using Electric Fields," P. Mansky, J. DeRouchey, J. Mays, M. Pitsikalis, T. Morkved, H. Jaeger and T. Russell, Macromolecules 13, 4399 S. Y. Chou, L. (1998). This research has been for systems of polymeric material that may be heated to temperatures that are slightly above their glass transition temperature. These viscous polymeric materials tend to react very slowly to the electric fields (order of several minutes) making them less desirable for commercial applications.

The embodiments described herein may potentially create lithographic patterned structures quickly (in a time of less than about 1 second). The structures may have sizes of tens of nanometers. The structures may be created by curing a polymerizable composition (e.g., a spin-coated UV curable liquid) in the presence of electric fields. Curing the polymerizable composition then sets the pattern of structures on the substrate. The pattern may be created by placing a template with a specific nanometer-scale topography at a carefully controlled nanoscale distance from the surface of a thin layer of the liquid on a substrate. If all or a portion of the desired structures are regularly repeating patterns (such as an array of dots), the pattern on the template may be considerably larger than the size of the desired repeating structures. The template may be formed using direct write e-beam lithography. The template may be used repeatedly in a high-throughput process to replicate nanostructures onto substrates. The template may be fabricated from a conducting material such as Indium Tin Oxide that is also transparent to UV light. The template fabrication process is similar to that of phase shift photomasks for optical lithography; phase shift masks require an etch step that creates a topography on the template.

The replication of the pattern on the template may be achieved by applying an electric field between the template and the substrate. Because the liquid and air (or vacuum) have different dielectric constants and the electric field varies locally due to the presence of the topography of the template, an electrostatic force may be generated that attracts regions of the liquid toward the template. At high electric field strengths, the polymerizable composition may be made to attach to the template and dewet from the substrate at certain points. This polymerizable composition may be hardened in place by polymerization of the composition. The template may be treated with a low energy self-assembled monolayer film (e.g., a fluorinated surfactant) to aid in detachment of the template the polymerized composition.

It may be possible to control the electric field, the design of the topography of the template and the proximity of the template to the liquid surface so as to create a pattern in the polymerizable composition that does not come into contact with the surface of the template. This technique may eliminate the need for mechanical separation of the template from the polymerized composition. This technique may also eliminate a potential source of defects in the pattern. In the absence of contact, however, the liquid may not form sharp, high-resolution structures that are as well defined as in the case of contact. This may be addressed by first creating structures in the polymerizable composition that are partially defined at a given electric field. Subsequently, the gap may be increased between the template and substrate while simultaneously increasing the magnitude of the electric field to "draw -out" the liquid to form clearly defined structures without requiring contact.

The polymerizable composition may be deposited on top of a hard-baked resist material to lead to a bi-layer process. Such a bi-layer process allows for the formation of low aspect ratio, high -resolution structures using the electrical fields followed by an anisotropic etch that results in high-aspect ratio, high-resolution structures. Such a bi-layer process may also be used to perform a "metal lift-off process" to deposit a metal on the substrate such that the metal is left behind after lift-off in the trench areas of the originally created structures.

By using a low viscosity polymerizable composition, the pattern formation due to the electric field may be fast (e.g., less than about 1 sec.), and the structure may be rapidly cured. Avoiding temperature variations in the substrate and the polymerizable composition may also avoid undesirable pattern distortion that makes nano-resolution layer-to-.layer alignment impractical. In addition, as mentioned above, it is possible to quickly form a pattern without contact with the template, thus eliminating defects associated with imprint methods that require direct contact.

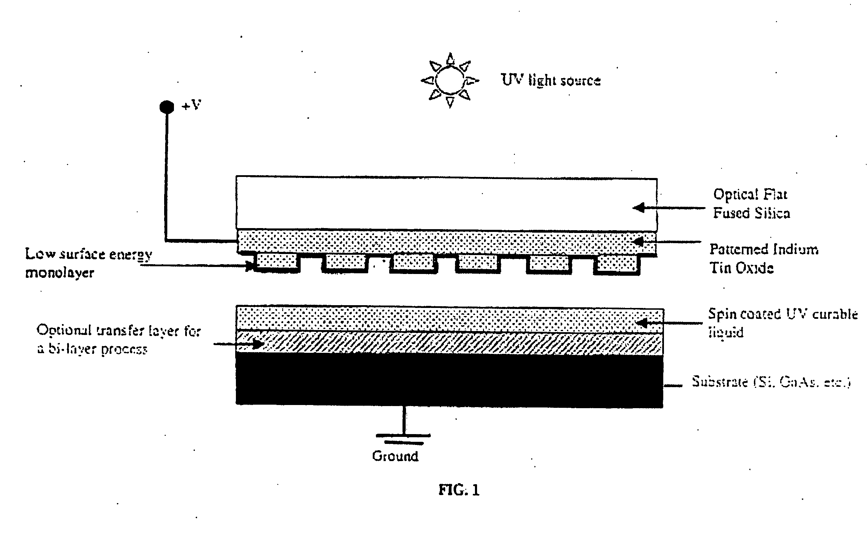

Figure 1 depicts an template and substrate designs. The template may be formed from a material that is transparent to activating light to allow curing of the polymerizable composition by exposure to activating light. Forming the template from a transparent material may also allow the use of established optical techniques to measure the gap between template and substrate and to measure overlay marks to perform overlay alignment and magnification correction during formation of the structures. The template may also be thermally and mechanically stable to provide nano-resolution patterning capability. The template may also include an electrically conducting material to allow electric fields to be generated at the template-substrate interface.

In Figure 1, a thick blank of fused silica has been chosen as the base material for the template. Indium Tin Oxide (ITa) may be deposited onto the fused Silica. ITa is transparent to visible and UV light and is a conducting material. ITa may be patterned using high-resolution e-beam lithography. A low-surface energy coating (for example, a fluorine containing self-assembly monolayer) may be coated onto the template to improve the release characteristics between the template and the polymerized composition. The substrate may include standard wafer materials such as Si, GaAs, SiGeC and InP. A UV curable liquid may be used as the polymerizable composition. The polymerizable composition may be spin coated onto the wafer. An optional transfer layer may be placed between the wafer and the liquid layer. This transfer layer may be used for bi-layer process. The transfer layer material properties and thickness may be chosen to allow for the creation of high- aspect ratio structures from low-aspect ratio structures created in the cured liquid material. An electric field may be generated between the template and substrate by connecting ITO to a voltage source.

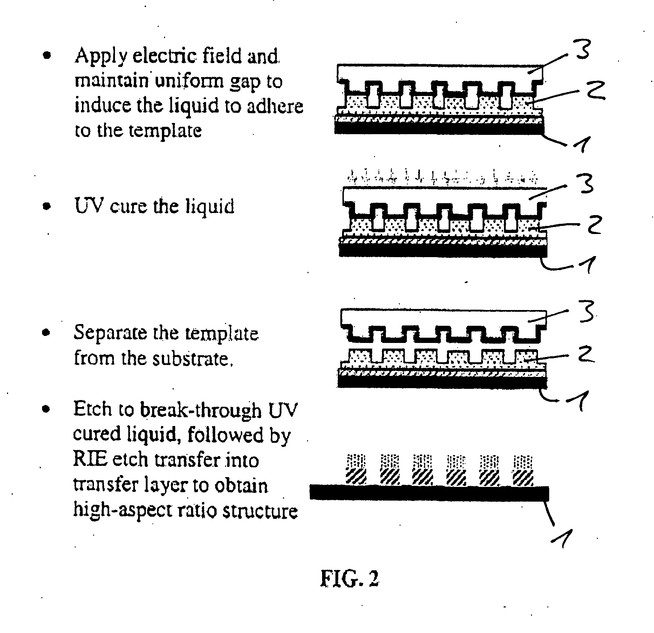

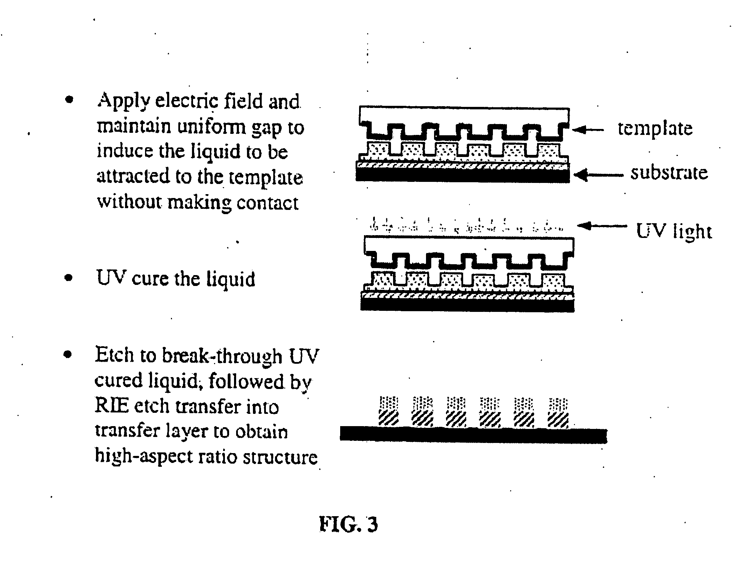

In Figures 2 and 3, two variants of the above-described process are presented. In each variant, it is assumed that a desired uniform gap may be maintained between the template and the substrate. An electric field of the desired magnitude may be applied resulting in the attraction of the polymerizable composition towards the raised portions of the template. In Figure 2, the gap and field magnitudes are such that the polymerizable composition makes direct contact and adheres to the template. A UV curing process may be used to harden the liquid in that configuration. Once the structures have been formed, the template is separated from the substrate by either increasing the uniform gap till the separation is achieved, or by initiating a peel and pull motion wherein the template is peeled away from the substrate starting at one edge of the template. Prior to its use, the template is assumed to be treated with a low-surface energy monolayer that assists in the separation step.

In Figure 3, the gap and field magnitudes are chosen such that the liquid achieves a topography that is essentially the same as that of the template. This topography may be achieved without making direct contact with the template. A UV curing process may be used to harden the liquid in that configuration. In both the processes of Figures 2 and 3, a subsequent etch process may be used to eliminate the residual layer of the UV cured material. A further etch may also be used if a transfer layer is present between the UV cured material and the wafer as shown in Figures 2 and 3. As mentioned earlier, such a transfer layer may be used to obtain high-aspect ratio structures from a low aspect ratio structure created in the UV cured material.

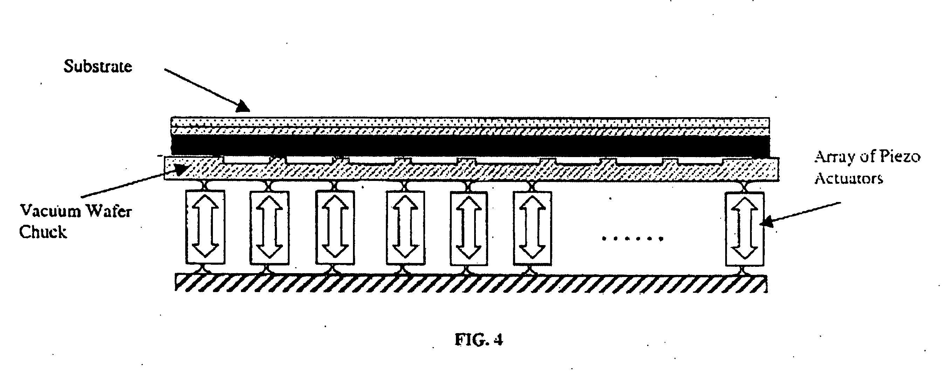

Figure 4 illustrates mechanical devices that may increase the planarity of the substrate. The template may be formed from high-quality optical flats of fused-silica with Indium Tin Oxide deposited on the fused silica. Therefore, the template typically possesses extremely high planarity. The substrates typically have low planarity. Sources of variations in the planarity of the substrate include poor finishing of the back side of the wafer, the presence of particular contaminants trapped between the wafer and the wafer chuck, and wafer distortions caused by thermal processing of the wafer. In one embodiment, the substrate may be mounted on a chuck whose top surface shape may be altered by a large array of piezoelectric actuators. The chuck thickness may be such that accurate corrections in surface topography of up to a few microns may be achieved. The substrate may be mounted to the chuck such that it substantially conforms to the shape of the chuck. Once the substrate is loaded on to the chuck, a sensing system (e.g., an optical surface topography measurement system) may be used to map the top surface of the substrate accurately. Once the surface topology is known, the array of piezoelectric actuators may be actuated to rectify the topography variations such that the upper surface of the substrate exhibits a planarity of less than about 1 µm. Since the template is assumed to be made from an optically flat material, this leads to template and substrate that are high quality planar surfaces.

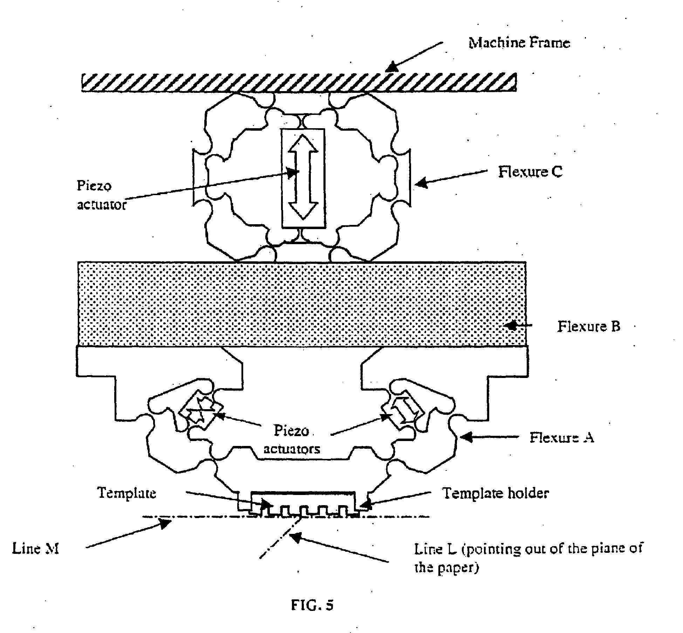

The mechanical device in Figure 5 may be used to perform a high -resolution gap control at the template-substrate interface. This device may control two tilting degrees of freedom (about orthogonal axes that lie on the surface of the template) and the vertical translation degree of freedom of the template. The magnitude of the gap between the template and the substrate may be measured in real-time. These real-time measurements may be used to identify the corrective template motions required about the tilting degrees of freedom and the vertical displacement degree of freedom. The three gap measurements may be obtained by using a broadband optical interferometric approach that is similar to the one used for measuring thicknesses of thin films and thin film stacks. This approach of capacitive sensing may also be used for measuring these three gaps.

The description is to be construed as illustrative only and is for the purpose of teaching those skilled in the art the general manner of carrying out the invention. It is to be understood that the forms of the invention shown and described herein are to be taken as the presently preferred embodiments. Elements and materials may be substituted for those illustrated and described herein, parts and processes may be reversed, and certain features of the invention may be utilized independently, all as would be apparent to one skilled in the art after having the benefit of this description of the invention. Changes may be made in the elements described herein without departing from the scope of the invention as defined in the following claims.

## Claims

1. A method of preparing patterned structures on a substrate (1), comprising:
applying a polymerizable composition (2) to a surface of the substrate (1);
positioning a template (3) proximate to the polymerizable composition (2), wherein at least a portion of the template (3) is electrically conductive; **characterized by** the method further comprising the step of :
applying an electric field between the template (3) and the substrate (1), wherein the applied electric field creates an electric static force that attracts a portion of the polymerizable composition (2) toward the template (3).

2. The method of claim 1, further comprising polymerizing the polymerizable composition (2).

3. The method of claim 1, wherein the polymerizable composition (2) is a liquid, preferably a low, viscosity liquid.

4. The method of claim 1, wherein the polymerizable composition (2) is a low viscosity liquid and wherein the viscosity of the polymerizable composition (2) is such that a pattern forms in the polymerizable composition (2) when the electric field is applied in less than about 1 second.

5. The method of claim 1, further comprising polymerizing the polymerizable composition (2), wherein the electric field is applied to the electrically conductive template (3) and the substrate (1) while polymerizing the polymerizable composition (2).

6. The method of claim 1, wherein the template (3) or the substrate (1) is transparent to visible and ultraviolet light.

7. The method of claim 1, wherein the template (3) further comprises a low-surface energy coating, preferably a fluorine containing coating.

8. The method of claim 1, wherein the polymerizable composition (2) is a thermally curable composition or an activating light curable composition.

9. The method of claim 1, wherein the polymerizable composition (2) is attracted to the template (3) but does not contact the template (3) when the electric field is applied to the template (3) and the substrate (1).

10. The method of claim 1, further comprising polymerizing the polymerizable composition (2) and etching the polymerized polymerizable composition (2).

11. The method of claim 1, wherein the substrate (1) comprises a silicon wafer or a GaAs wafer or a SiGeC wafer or a InP wafer.

12. The method of claim 1, wherein applying the electric field to the template (3) and the substrate (1) causes a portion of the polymerizable composition (2) to contact a portion of the template (3).

13. The method of any of claims 1 to 5 and 8 to 12, comprising applying a plurality of forces to the substrate (1) such that the shape of the substrate (1) is altered.

## Patentansprüche

1. Verfahren zur Herstellung von Musterstrukturen auf einem Substrat (1) umfassend:
Auftragen einer polymerisierbaren Zusammensetzung (2) auf einer Oberfläche des Substrats (1);
Positionieren eines Templets (3) in der Nähe der polymerisierbaren Zusammensetzung (2), wobei wenigstens ein Teil des Templets (3) elektrisch leitfähig ist;
**dadurch gekennzeichnet, dass** das Verfahren ferner die folgenden Schritte aufweist:
Anlegen eines elektrischen Feldes zwischen dem Templet (3) und dem Substrat (1), wobei das angelegte elektrische Feld eine elektrostatische Kraft erzeugt, die einen Teil der polymerisierbaren Zusammensetzung (2) zu dem Templet (3) hin zieht.

2. Verfahren nach Anspruch 1, ferner umfassend das Polymerisieren der polymerisierbaren Zusammensetzung (2).

3. Verfahren nach Anspruch 1, worin die polymerisierbare Zusammensetzung (2) eine Flüssigkeit, vorzugsweise eine Flüssigkeit mit niedriger Viskosität, ist.

4. Verfahren nach Anspruch 1, worin die polymerisierbare Zusammensetzung (2) eine Flüssigkeit mit niedriger Viskosität ist, und worin die Viskosität der polymerisierbaren Zusammensetzung (2) derart ist, dass ein Muster sich in der polymerisierbaren Zusammensetzung (2) ausbildet, wenn das elektrische Feld in weniger als etwa 1 Sekunde angelegt wird.

5. Verfahren nach Anspruch 1, ferner umfassend das Polymerisieren der polymerisierbaren Zusammensetzung (2), wobei das elektrische Feld an das elektrisch leitfähige Templet (3) und das Substrat (1) angelegt wird, während die polymerisierbare Zusammensetzung (2) polymerisiert wird.

6. Verfahren nach Anspruch 1, worin das Templet (3) und das Substrat (1) gegenüber sichtbarem und ultraviolettem Lichttransparent transparent ist.

7. Verfahren nach Anspruch 1, worin das Templet (3) ferner eine Beschichtung mit niedriger Oberflächenenergie aufweist, vorzugsweise eine Fluor enthaltende Beschichtung.

8. Verfahren nach Anspruch 1, worin die polymerisierbare Zusammensetzung (2) eine hitzehärtbare Zusammensetzung oder eine durch Aktivierungslicht aushärtbare Zusammensetzung ist.

9. Verfahren nach Anspruch 1, worin die polymerisierbare Zusammensetzung (2) zu dem Templet (3) hingezogen wird, das Templet (3) jedoch nicht berührt, wenn das elektrische Feld an das Templet (3) und das Substrat (1) angelegt wird.

10. Verfahren nach Anspruch 1, ferner umfassend das Polymerisieren der polymerisierbaren Zusammensetzung (2) und das Ätzen der polymerisierten, polymerisierbaren Zusammensetzung (2).

11. Verfahren nach Anspruch 1, worin das Substrat (1) ein Siliziumwaver oder ein GaAs-Waver oder ein SiGeC-Waver oder ein InP-Waver ist.

12. Verfahren nach Anspruch 1, worin das Anlegen des elektrischen Feldes an das Templet (3) und das Substrat (1) bewirkt, dass ein Teil der polymerisierbaren Zusammensetzung (2) mit einem Teil des Templets (3) in Kontakt kommt.

13. Verfahren nach einem der Ansprüche 1 bis 5 und 8 bis 12, umfassend das Anlegen einer Vielzahl von Kräften an das Substrat (1), so dass die Form des Substrats (1) verändert wird.

## Revendications

1. Procédé pour préparation de structures à motifs sur un substrat (1) comprenant:
- appliquer une composition polymérisable (2) à une surface du substrat (1);
- positionner un gabarit (3) près de la composition polymérisable (2) où au moins une portion du gabarit (3) est électriquement conductrice; et
**caractérisé par** le procédé comprenant de plus l'étape de:
- appliquer un champ électrique entre le gabarit (3) et le substrat (1), où le champ électrique appliqué crée une force statique électrique qui attire une portion de la composition polymérisable (2) vers le gabarit (3).

2. Procédé selon la revendication 1, comprenant de plus la polymérisation de la composition polymérisable (2).

3. Procédé selon la revendication 1, où la composition polymérisable (2) est un liquide, préférablement un liquide de basse viscosité.

4. Procédé selon la revendication 1, où la composition polymérisable (2) est un liquide de basse viscosité et où la viscosité de la composition polymérisable (2) est de sorte qu'un motif se forme dans la composition polymérisable (2), quand le champ électrique est appliqué en moins qu'environ 1 seconde.

5. Procédé selon la revendication 1, comprenant de plus la polymérisation de la composition polymérisable (2), où le champ électrique est appliqué au gabarit électriquement conducteur (3) et au substrat (1) pendant qu'en polymérisant la composition polymérisable (2).

6. Procédé selon la revendication 1, où le gabarit (3) ou le substrat (1) est transparent à lumière visible et ultraviolette.

7. Procédé selon la revendication 1, où le gabarit (3) comprend de plus une enveloppe énergétique de surface inférieure préférablement une enveloppe contenant de la fluorine.

8. Procédé selon la revendication 1, où la composition polymérisable (2) est une composition thermiquement curable ou une composition curable à la lumière d'activation.

9. Procédé selon la revendication 1, où la composition polymérisable (2) est attirée au gabarit (3) mais ne contacte pas le gabarit (3), quand un champ électrique est appliqué au gabarit (3) et au substrat (1).

10. Procédé selon la revendication 1, comprenant de plus la polymérisation de la composition polymérisable (2) et la gravure de la composition polymérisable polymérisée (2).

11. Procédé selon la revendication 1, où le substrat (1) comprend une galette de silicium ou une galette GaAs ou une galette SiGeC ou une galette lnP.

12. Procédé selon la revendication 1, où en appliquant le champ électrique au gabarit (3) et au substrat (1) celui cause qu'une portion de la composition polymérisable (2) contacte une portion du gabarit (3).

13. Procédé selon l'une quelconque des revendications 1 à 5 et 8 à 12, comprenant l'application d'une pluralité de forces au substrat (1) de sorte que la forme du substrat (1) est altérée.
